# EUROPEAN PATENT APPLICATION

(11) **EP 1 847 344 A1**
(43) Date of publication of application: **24.10.2007**
(21) Application number: 05816476.5
(22) Date of filing: 16.12.2005
(51) Int. Cl.: B22F 1/00, B22F 9/24

(54) **SUPERFINE COPPER POWDER SLURRY AND PROCESS FOR PRODUCING THE SAME**

(30) Priority: 22.12.2004 JP 2004371493
(71) Applicant: Mitsui Mining & Smelting Co., Ltd, Tokyo 141-8584 (JP)
(72) Inventor: YOSHIMARU, Katsuhiko, Hikoshima Smelting Co. Ltd., Shimonoseki-shi, Yamaguchi 750-0093 (JP); SAKAUE, Takahiko, Hikoshima Smelting Co. Ltd., Shimonoseki-shi, Yamaguchi 750-0093 (JP); NAKAMURA, Yoshinobu, Hikoshima Smelting Co., Ltd., Shimonoseki-shi, Yamaguchi 750-0093 (JP); AOKI, Akira, Hikoshima Smelting Co., Ltd., Shimonoseki-shi, Yamaguchi 750-0093 (JP)
(74) Representative: Bohmann, Armin K.
(86) International application number: PCT/JP2005/023176
(87) International publication number: WO 2006/068061

(57) **Abstract**

It is an object to provide a superfine copper powder slurry which enables finer-pitch wirings formation on the substrates when it is used for an electroconductive ink or an electroconductive paste for wirings. In order to achieve the object, a superfine copper powder slurry produced by suspending a superfine copper powder having powder characteristics of the value D_{TEM} (micron meter) of 0.01 to 0.1, the ratio D_{50/}D_{TEM} of 1.0 to 1.5 and the ratio grain size/D_{TEM} of 0.2 to 1 in a solvent, where *(D_{TEM} is)* an average primary particle diameter of the powder particle diameter directly measured from observation image of TEM and calculated with observation magnification, and D₅₀ is a particle diameter at 50% cumulative particle size examined by Doppler scattering photo analysis.

## Description

### Technical Field

The present invention relates to a superfine copper powder slurry and production method thereof.

### Background Art

As the methods for forming electrodes or wirings of the electric circuits for electronic devices and the like, a method printing an electroconductive paste or an electroconductive ink which comprises copper powder as an electroconductive filler on a substrate is widely used. For example, a copper powder is used as a raw material of an electroconductive paste or an electroconductive ink to be mixed with an organic compound, e.g., terpineol, after being slurry form.

In recent years, methods to form wirings or the like on a substrate or the like easily by directly coating an electroconductive paste or an electroconductive ink by ink jet printing, screen printing or off-set printing have been developed and utilized. (It should be noted that utilizable application of an electroconductive paste or an electroconductive ink is not limited to the above mentioned applications.)

On the other hand, there is additional demands for making finer on electronic circuits which is formed by using an electroconductive ink or the like and for miniaturizations with higher density in electronic devices, as a results, finer wiring patterns (finer-pitch patterns) are required for forming electronic circuits. So, for copper powder, which is a popular electroconductive metallic material used as an electroconductive slurry as raw material for an electroconductive ink, requirement to be finer and to have sharper particle size distribution has been particularly coming out.

For forming fine-pitch patterns, a superfine copper powder has been sometimes used as a material for electroconductive slurry. However, powders which can satisfy characteristics are hardly found, and some under investigations are intentionally comprising an additives, oxidation inhibitor or dispersing agent or else.

For example, a technology relating to fine copper powder is disclosed in Patent Document 1, in which a dispersing agent and oxidation inhibitor are used to produce fine powder with improved dispersibility, and invariably copper powder particles are coated with a material which is difficult to be decomposed at low temperature.

[Patent Document 1]: Japanese Patent Laid-Open No. 2004-211108

However, hardness in the method disclosed in Patent Document 1 to achieve above described lower resistance of the wirings is suspected. It is because if the above additives were used, the additives remaining on the copper particle surfaces may cause problems i.e. increasing resistivity of the electroconductive wirings formed by using the copper powder.

On the other hand, an electroconductive ink or an electroconductive paste comprising fine gold or fine silver powder (particle size: below 100 nano meter) as a filler has drawback in cost of materials, because gold and silver itself is expensive. Moreover, an electroconductive ink or an electroconductive paste comprising fine silver powder has drawback in tendency to cause a so-called migration phenomenon . In consideration of suchpoints, fine copper powder is superior to fine gold powder or fine silver powder as a material for an electroconductive ink or an electroconductive paste.

From the view point shown above, it is an object of the present invention to provide a superfine copper powder superior in particle dispersibility and show less agglomeration, and superior in low temperature sintering property by less contamination on the particle surface.

### Disclosure of the Invention

The inventors of the present invention have developed a superfine copper powder slurry and producing method thereof described below after extensive studies, and recognized that the above objects can be achieved.

The superfine copper powder and the superfine copper powder slurry according to the present invention will be described below.

The superfine copper powder of the present invention satisfies the powder characteristics of the value D_{TEM} (micron meter) of 0.01 to 0.1 and the ratio D₅₀/D_{TEM} of 1 to 1.5. In addition, the powder satisfying the ratio grain size/D_{TEM} of 0.2 to 1 is preferable. The reasons why the above powder characteristic ranges are specified are described below.

As for the value D_{TEM}, if it was larger than 0.1 micron meter, fine-pitch wirings with pitch less than 50 micron meter now in demand may be hardly performed. Also, if it was larger than 0.1 micron meter, when the electroconductive ink comprising a super fine copper powder slurry of the present invention is applied to ink jet printing, clogging of the nozzle may tends to occur to make it difficult to write wiring pattern, and may tends to result defect of open circuits. On the other hand, if the value D_{TEM} was smaller than 0.01 micron meter, problems caused by agglomerating of the superfine copper particles with each other may come up.

As for the ratio D₅₀/D_{TEM}, meaning of the ratio closer to 1 is superior dispersibility, so the super fine copper powders which have the ratio D₅₀/D_{TEM} closer to 1 is suitably suppressed in particle agglomeration. Again, the value D_{TEM} is actual particle diameter directly measured from observation image of TEM and calculated with observation magnification.

If the ratio D_{50/}D_{TEM} was larger than 1.5, dispersibility in the ink or paste medium tends to inferior when the superfine copper powder slurry of the present invention is used for production of an electroconductive ink or an electroconductive paste.

As for the ratio grain size/ D_{TEM}, if it was below 0.2, crystallinity of copper particles may insufficient and oxidation resistance decrease accordingly. On the other hand, in the case the ratio of over 1, the grain may be the copper particle itself theoretically.

D₅₀ is a particle diameter at 50% cumulative particle size examined by Doppler scattering photo analysis.

The value D_{TEM} is an average primary particle diameter of the powder particle size directly measured from printed image obtained from TEM observation by using transmission electron microscope on the samples and calculated with observation magnification.

The grain size is a value calculated from a half-width of the diffraction angle peak on the crystal plane obtained by powder X-ray diffractiometry on the sample.

The present invention also provides a superfine copper powder slurry produced by suspending the above-described superfine copper powder in an organic solvent. It is used as a material for an electroconductive paste or an electroconductive ink, as described above.

The reason why to be a slurry form is that the superfine copper powder tends to agglomerate with each other when they are dry, and also it tends to be oxidized because the relative surface area of the super fine copper powder is very wide. Therefore, to ease preparation of an electroconductive slurry in the following process or to prevent oxidation while storing in temporarily or in transportation, it is preferable to suspend the superfine copper powder in an organic solvent, e.g., methanol, ethanol, propyl alcohol, acetone, methylethylketone (MEK), terpineol, ethylene glycol or the like to be the state of the superfine copper powder slurry.

The method for producing the superfine copper powder slurry will be described in Best Mode for Carrying out the Invention below.

The finer-pitch wirings (line width of less than 50 micron meter) can be formed on a substrate when conductor is formed by using an electroconductive paste or an electroconductive ink which is produced by using the superfine copper powder slurry of the present invention.

### Brief Description of the Drawing

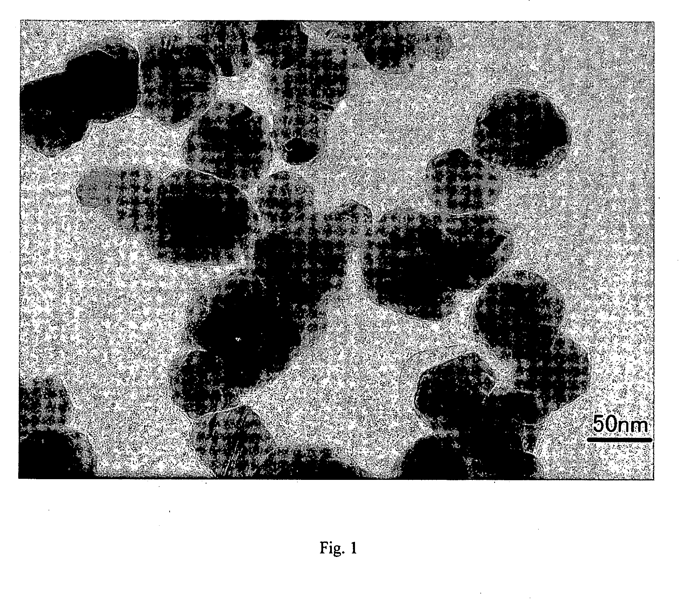

Figure 1 is a TEM image showing the superfine copper powder of the present invention (magnification: 100,000).

### Best Mode for Carrying Out the Invention

The best mode for carrying out the invention, especially on the production method is described below. In following descriptions, it is needless to say that quantities of reagents, solutions and so forth are not limited to those described. Also it may be understood that persons skilled in the related art can optionally arrange them and other conditions for carrying out the present invention depending on the scales, pilot scale or mass production scale.

The method for producing the superfine copper powder slurry of the present invention comprises the following steps:
Step (a) : The step to prepare a slurry containing cupric oxide by charging an alkaline solution into an aqueous solution containing a copper salt and complexing agent,
Step (b) : The step to prepare a slurry containing cuprous oxide by charging a first reducing agent to the slurry containing cupric oxide prepared in Step (a), and
Step (c) : The step to prepare a superfine copper powder slurry containing copper (Cu) powders by charging a second reducing agent which is mixture of two or more kinds of reducing agents into the slurry prepared in step (b) .
Also, the method will be described in detail below with someparts in the above steps. In following parts, dissolution part to temperature adjustment part are included in step (a), first reduction part is included in step (b), and second reduction part is included in step (c).

Dissolution part: 400 to 1000 g of copper salt, e.g., copper sulfate pentahydrate (CuSO₄/5H₂O), is dissolved in 0.5 to 1.0 L of water kept at 50 to 90 deg. C. As for water to be used here, pure water such as de-ionized water is preferred ("water" described hereinafter means the same).

Complex forming part: A copper complex is prepared by adding an amino acid, e.g., glycine, at 0.005 to 10 mol per mol of copper (Cu) into copper sulfate solution prepared above.
Concentration adjusting part: After forming the above copper complex, water is charged to an aqueous copper sulfate solution to adjust a concentration to be 1.0 to 2.5 M*(ol*/*L)* as a whole, with stirring for 10 to 60 minutes while adjusting the concentration.

Neutralizing part: After finishing concentration adjusting part, the resulting solution is continuously stirred and neutralized in 10 to 120 minutes with 0.50 to 5.00 kg of an aqueous NaOH solution having concentration of 20 to 50% by weight.

Temperature adjusting part: After finishing neutralizing part, the neutralized solution is stirred for 10 to 30 minutes with managing the solution temperature to be at 50 to 90 deg. C as a whole.

First reduction part: After finishing temperature adjusting part, cuprous oxide (Cu₂O) is formed by adding 150 to 500 g of glucose which is a reducing sugar as a first reducing agent into the solution all at once to occur reduction while the solution at 50 to 90 deg. C has been stirred for 30 to 90 minutes. As for reducing sugar, it is not limited so long as it can achieve the reduction to form cuprous oxide (Cu₂O) . Above example is shown because if glucose was especially used, dispersibility of the superfine copper powder is improved.

Second reduction part: After finishing first reduction part, copper (Cu) is precipitated by adding a second reducing agent, which is a mixture of boron hydride compound and at least one another reducing agent into the slurry prepared in first reduction part to occur reduction while stirring for 60 minutes. Boron hydride compound is preferably sodium boronhydride (SBH) orpotassiumboronhydride. For the second reducing agent, it is preferable to use hydrazine or formalin as another reducing agent with boron hydride compound as the essential component.

As shown above, the superfine copper powder is prepared by using the reducing agent in combination of boron hydride and another reducing agent in the second reduction part. Although the reaction mechanisms involved are not fully understood, but the core formation be controlled separately from the particle growing may be probably important. More specifically, it is considered that performance of the combination boron hydride compound (e.g., sodium boron hydride, SBH) and another reducing agent (e.g., hydrazine or formalin as a reducing sugar) which is weaker than boron hydrate compounds is that the stronger reducing agent is responsible for forming a number of copper core particles and the weaker reducing agent contributes to growth of the core to produce the superfine copper powder with high dispersibility. However, it should be paid attention in the production that the copper particles may agglomerate with each other when a boron hydride compound is too much.

The present invention also provides the method for forming the superfine copper powder slurry, steps (a) to (c) is preferably followed by step (d) and step (e) described below.

Step (d): Rinsing step to rinse the superfine copper powder in the slurry, and
Step (e) : The step to finish the superfine copper powder slurry in which the superfine copper powder is suspended in a liquid by crushing the superfine copper powder rinsed in step (d). These steps are described below one by one.

Step (d) (rinsing step) : In the production method, the reaction finished solution containing the superfine copper powder in the slurry is rinsed by decantation with the water (preferably pure water), followed by further decantation with an organic solvent preferably a polar organic solvent, e.g., ethylene glycol, alcohol, MEK or the like, to perform rinsing and elimination of the water at the same time.

Step (e) (dispersing step) : The superfine copper powder is produced by dispersing the slurry containing the decantation-rinsed superfine copper powder after it is dried or as slurry in the organic solvent (organic solvent with higher boiling point is preferable), by using a disperser, Ultimizer (Sugino Machine) under condition of a pressure of 100 to 400 MPa, where the copper particles are allowed to collide with each other and the processing may be repeated once to 20 times to disperse the particles, in order to result the particles in the slurry dispersed in the state of nearly monodisperse.

Step (e) of dispersing step is adopted to improve dispersibility of the superfine copper powder. The particles are preferably dispersed by a wet process, for which an apparatus such as Harel homogenizer, Ultimizer, Filmics, bead mill or the like may be used. Moreover, in powder dispersing (crushing) step, the slurry may contain a dispersing agent, e.g., gum Arabic, glue, gelatin, PVA, PVP, PEI or the like.

After above described crushing, the superfine copper powder of the present invention is obtained as shown in a TEM image (magnification: 100,000) in Figure 1.

### Examples 1, 2 (and 3) of the present invention and Comparative Example will be described below.

### [Example 1]

Dissolution part: 800 g of copper sulfate pentahydrate (CuSO_{4/}5H₂O) was dissolved into 1.0 L of de-ionized water at 80 deg. C.

Complexing part: 24.1 g of glycine was added to the copper sulfate solution prepared in the above part to form the copper complex.

Concentration adjusting part: After finishing of forming copper complex, de-ionized water was added to adjust the concentration of the copper sulfate solution to be 2 M(*ol*/*L)* as a whole while stirring for 30 minutes.

Neutralization part: For neutralization, 1.28 kg of the aqueous solution with NaOH concentration of 25% by weight was added in 30 minutes while stirring into the above solution adjusting of concentration is finished.

Temperature adjusting part: The neutralized solution above was made to be at 70 deg. C as a whole while stirring.

First reduction part: After finishing temperature adjusting part, 289 g of glucose was added all at once into the solution, and cuprous oxide (Cu₂O) is prepared while the resulting solution at 70 deg. C was reduced with stirring for 60 minutes.

Second reduction part: Next, a mixed reducing agent of 200 g of 100% by weight hydrazine (N₂H₄) and 0.2 g of sodium boron hydride (SBH) was added into the solution prepared in the above first reduction part at 50 deg. C all at once for reduction while stirring for 60 minutes to form the superfine copper powder.

### [Example 2]

The superfine copper powder was produced in the same manner as in Example 1, except that in the second reduction part, a mixed reducing agent of 200 g of 100% by weight hydrazine (N₂H₄) and 0.2 g of SBH into the solution prepared in first reducing part at 70 deg. C all at once while stirring for 30 minutes for reduction to form the superfine copper powder. Another processes or parts are performed in same conditions with Example 1, so descriptions are omitted.

### [Example 3]

After finishing decantation-rinsing with pure water on the reaction finished solution containing the superfine copper powder prepared in Example 2 was dispersed in the pure water to prepare a copper powder slurry. By using Ultimizer (Sugino Machine) under condition of a pressure of 245 MPa, processing of copper particles allowing to collide with each other was repeated for 5 times to disperse the particles, then the slurry with the well dispersed particles was produced.

### [Comparative Example]

In the comparative example, the same manner as in Example 2 was carried out, except the second reduction part. It is that 100% by weight hydrazine (N₂H₄) was added all at once into the solution prepared in first reducing part for reduction while stirring for 60 minutes to form the superfine copper powder.

To compare average particle size, powder dispersibility and particle crystallinity of the superfine copper particles, the superfine copper powders prepared in examples and comparative example were examined on D₅₀, the value D_{TEM} and grain size to determine the ratio D_{50/}D_{TEM} and the ratio grain size/D_{TEM}.

D₅₀ is a particle diameter examined by an analyzer (Nanotrac UPA150, NIKKISO) . It is a particle diameter at 50% cumulative particle size examined by Doppler scattering photo analysis, where the copper particles with Brownian motion in water are irradiated with laser beams through an optical fiber to detect diameter information of the Doppler-shifted copper particles. The copper particles were dispersed in water as a pretreatment for examination.

The value D_{TEM} is an average primary particle diameter (number sampled is 30), obtained by observing a sample particle using a transmission electron microscope (JEM-4000EX, JEOL) at an acceleration voltage of 400 kV, directly measuring the powder particle diameters from the TEM image photograph, and calculating with observation magnification.

Grain size is examined by a powder X-ray diffractiometer (RINT2000PC, Rigaku), and calculated from a half-width of the diffraction angle peak on the crystal plane.

**[Table 1]**

| | D_{TEM} | D₅₀ | Grain size (nm) | Ratio | |
|---|---|---|---|---|---|
| | (micron meter) | | | D₅₀/D_{TEM} | grain size /D_{TEM} |
| Example 1 | 0.060 | 0.064 | 12 | 1.0 | 0.20 |
| Example 2 | 0.028 | 0.033 | 10 | 1.2 | 0.36 |
| Example 3 | 0.027 | 0.030 | 9 | 1.1 | 0.33 |
| Comparative Example | 0.200 | 0.310 | 16 | 1.6 | 0.08 |

### <Overall evaluation>

According to the values of the value D_{TEM}, the ratio D₅₀/D_{TEM} and the ratio grain size/D_{TEM} given in Table 1, it is found that the copper powder prepared in each of Examples 1, 2 *(and* 3) has a smaller particle diameter (the value D_{TEM}), more dispersible and higher in crystallinity than the one prepared in Comparative Example.

Example 2 adopting a higher temperature and shorter reaction time in the second reduction part gave the finer copper powder than example 1. In comparison of example 2 with example 3, the copper powder prepared in Example 3 shows the ratio D_{50/}D_{TEM} some extent lower **(than that prepared *in Example* 2),** so thepowderbreaking stepmayprobablyresult the improved dispersibility.

As described above, it is found that the methods according to the Examples 1 to 3 of the present invention can produce a superfine copper powder suitable for slurrification with superior dispersibility without impurities such as oxidation inhibitor, dispersing agent or the like, which is intentionally added in conventional technologies.

### Industrial Applicability

The superfine copper powder slurry of the present invention is suitable for forming wirings on electronic substrates in which high quality and high wiring density is required. Because the superfine copper powder contained in the slurry is used as a filler for an electroconductive ink or an electroconductive paste, it may ease to perform fine pitch in conductor such as circuits or the like formed on the substrates.

## Claims

1. A superfine copper powder having a value D_{TEM} (micron meter) of 0.01 to 0.1 and the ratio D_{50/}D_{TEM} of 1 to 1.5, where D_{TEM} is an average primary particle diameter of the powder particle diameter directly measured from observation image of TEM and calculated with observation magnification, and D₅₀ is a particle diameter at 50% cumulative particle size examined by Doppler scattering photo analysis, and these definitions are common in the specification.

2. The superfine copper powder according to Claim 1 which has the ratio grain size/ D_{TEM} of 0.2 to 1, where the grain size is determined by X-ray diffractiometry and the def inition is common in the specification.

3. A superfine copper powder slurry produced by suspending the superfine copper powder according to Claim 1 or 2 in a solvent.

4. A method for producing a superfine copper powder slurry, comprising the following steps (a) to (c):
Step (a) : The step to prepare a slurry containing cupric oxide by charging an alkaline solution into an aqueous solution containing a copper salt and complexing agent,
Step (b) : The step to prepare a slurry containing cuprous oxide by charging a first reducing agent to the slurry containing cupric oxide prepared in Step (a), and
Step (c) : The step to prepare a superfine copper powder slurry containing copper (Cu) powders by charging a second reducing agent which is mixture of two or more kinds of reducing agents into the slurry prepared in Step (b).

5. The method for producing a superfine copper powder slurry according to Claim 4, wherein the second reducing agent is the solution containing a boron hydride compound.

6. The method for producing a superfine copper powder slurry according to Claim 4 or 5, wherein the second reducing agent is the solution containing hydrazine.

7. The method for producing a superfine copper powder slurry according to any one of Claims 4 to 6, wherein the first reducing agent is the solution containing a reducing sugar.

8. The method for producing a superfine copper powder slurry according to any one of Claims 4 to 7, which further comprises the following Steps (d) and (e):
Step (d): Rinsing step to rinse the superfine copper powder in the slurry, and
Step (e) : The step to finish the superfine copper powder slurry in which the superfine copper powder is suspended in a liquid by crushing the superfine copper powder rinsed in Step (d).
